# EUROPÄISCHE PATENTSCHRIFT

(11) **EP 2 539 772 B1**
(45) Veröffentlichungstag und Bekanntmachung des Hinweises auf die Patenterteilung: **02.09.2015**
(21) Anmeldenummer: 11709860.8
(22) Anmeldetag: 15.02.2011
(51) Int. Cl.: G03F 7/20, B41J 2/45

(54) **BELICHTUNGSVORRICHTUNG ZUR HERSTELLUNG VON DRUCKVORLAGEN UND VERWENDUNG EINER BELICHTUNGSVORRICHTUNG**
EXPOSURE DEVICE FOR PRODUCING PRINTING FORMS AND USE OF SAME
DISPOSITIF D'EXPOSITION DESTINÉ À LA FABRICATION DE PLAQUES D'IMPRESSION ET UTILISATION D'UN DISPOSITIF D'EXPOSITION

(30) Priorität: 23.02.2010 EP 10405033
(43) Veröffentlichungstag der Anmeldung: 02.01.2013
(73) Patentinhaber: Lüscher Technologies AG, 3368 Bleienbach (CH)
(72) Erfinder: BERNER, Peter, CH-5102 Rupperswil (CH); WEBER, Franz, CH-5524 Niederwil / AG (CH)
(74) Vertreter: EGLI-EUROPEAN PATENT ATTORNEYS
(86) Internationale Anmeldenummer: PCT/EP2011/000688
(87) Internationale Veröffentlichungsnummer: WO 2011/103972

(56) Entgegenhaltungen:
- EP-A1- 1 892 576
- DE-A1- 10 010 574
- DE-A1- 19 836 330
- US-A- 5 784 171
- US-A1- 2003 052 105

## Beschreibung

Die Erfindung betrifft eine Belichtungsvorrichtung zur Herstellung von Druckvorlagen nach Patentanspruch 1 und eine Verwendung einer Belichtungsvorrichtung nach Patentanspruch 16.

In der Drucktechnik dient eine Druckvorlage unmittelbar zur Herstellung einer Druckform als zweidimensionale Vorlage, die als Produktionsergebnis einer Reprotechnik, beispielsweise eine Repröfotografie, geschaffen wird. Bei dem weit verbreitet verwendeten Offsetdruck dient hierzu in der Riegel ein Lithfilm. Seit der Einführung der digitalen Druckplattenbelichtung CtP (CtP: Computer to Plate) werden im übertragenen Sinn auch bestimmte zur Vervielfältigung im Druck vorgesehene Daten (beispielsweise Bilddateien und allgemein verbreitet PDF-Dateien) als Druckvorlagen bezeichnet. Im Gegensatz zurindirekten Bebilderung über konventionelle Filmbelichtungsverfahren werden durch die digitale Druckplattenbelichtung CtP auch Kosten hinsichtlich der Montage und des Filmmaterials eingespart. Zudem lassen sich mithilfe direkt bebildeter Druckplatten sehr hochwertige Druckergebnisse erzeugen, da die Randschärfe der Rasterpunkte höher ist und kleinere Rasterpunkte erzeugt werden können. Ein weiterer Vorteil dieses Verfahrens besteht darin, dass mechanische Einflüsse auf die Druckplatten reduziert werden können, wie beispielsweise Fehlbelichtungen, Staub und Kratzer.

Im Stand der Technik sind drei Konstruktionsprinzipien einer CtP-Anlage bekannt, nämlich ein Aussentrommel-Belichter, ein Innentrommel-Belichter und ein Flachbett-Belichter. Bei dem zuletzt genannten Flachbett-Belichter sind zwei Arten unterscheidbar, nämlich zum einen ein Flachbett-Belichter, bei welchem die Druckplatten unter dem Belichtungskopf vorbeigeführt werden (Capstan-Prinzip), und zum anderen ein Flachbett-Belichter, bei welchem der Belichtungskopf horizontal und vertikal (X- und Y-Achse) über die Druckplatte geführt wird.

Der Flachbett-Belichter gemäss dem Capstan-Prinzip zeichnet sich durch seine einfache Konstruktionsweise und schnelle Bebilderung aus. Ein zur Bestrahlung notwendiger Polygonspiegel ist hierbei mittig angebracht. Nachteilig hieran ist, dass es zu geometrischen Verzerrungen des Laserpunktes kommen kann, wodurch die Rasterpunkte unscharf abgebildet werden. Eine optische Korrektur ist insbesondere bei grossen Druckplatten sehr aufwendig. Insgesamt lassen sich hierbei lediglich Druckplatten bis zu einer Breite von ungefähr 70 cm belichten.

Der Flachbett-Belichter nach dem Prinzip der X- und Y-Achse zeichnet sich durch seine einfache Konstruktionsweise, schnelle Bebilderung, präzise Abbildung der Rasterpunkte und gleichmässige Kalibrierung über die gesamte Druckplatte aus. Da der Belichtungskopf insbesondere in Richtung der Breite der Druckplatte sehr schnell reziprok über die Druckplatte bewegt werden muss, treten hohe Beschleunigungskräfte des Belichtungskopfes auf. Somit unterliegt die Belichtungsgeschwindigkeit einigen Beschränkungen. Zusätzlich müssen einige Flachbett-Belichter mit grossen und schweren Schwungmassen bestückt werden, um die Beschleunigungskräfte abzufangen, damit die Flachbett-Belichter im Betrieb insgesamt überhaupt stationär verbleiben.

Mittels der Druckform werden Texte, Bilder und Strichelemente bei den unterschiedlichen Druckverfahren mittels Farbe auf den zu bedruckenden Stoff übertragen. In Abhängigkeit des eingesetzten Druckverfahrens wechselt die Art der Druckform. Bekannt sind der Buchdruck, der Tiefdruck, der Offsetdruck, der Siebdruck und der Flexodruck. Beim Buchdruck setzt sich die Form aus Lettern und Klischees zusammen. Beim Tiefdruck werden geätzte und gravierte Zylinder eingesetzt. Beim Offsetdruck wird lediglich von einer Druckplatte aus gedruckt. Beim Siebdruck besteht die Druckform aus einem Sieb mit einer Schablone. Beim Flexodruck wird mit einem direkt gravierten Gummi-Zylinder oder einer digital bebilderten Polymer-Druckform gearbeitet. Zusätzlich ist ein Druckverfahren ohne Druckform bekannt, nämlich das sogenannte NIP-Verfahren (NIP: Non Impact Printing). Das NIP-Verfahren ist ein Druckverfahren in der Drucktechnik, welches ohne feste Druckform (beispielsweise Druckzylinder) auskommt und prinzipiell von Druck zu Druck eine Seite unerschiedlich bedrucken kann. Beispiele für NIP-Verfahren sind Tintenstrahldruck (Ink-Jet-), Elektrofotografie, Ionografie, Magnetografie, Thermografie und Fotografie (Verwendung bei Fotopapieren, die von digital angesteuerten Lasersystemen bebildert werden).

Zu dem arm häufigsten verwendeten Druckverfahren gehört allerdings das Siebdruck-Verfahren. Hierbei werden spezielle Gewebe mit unterschiedlichen Feinheiten eingesetzt. Der Vorteil des Siebdruck-Verfahrens liegt darin, dass der Farbauftrag je nach Gewebefeinheit variiert werden kann, und dass viele verschiedenartige Farbsysteme (Farbsorten) verdruckt werden können. Hierbei ergeben Gewebe mit geringer Siebfeinheit einen hohen Farbauftrag, wie dies beispielsweise im Textildruck gewünscht ist. Hierbei können allerdings keine feinen Linien oder Raster gedruckt werden, weil das grobe Gewebe die feinen Schablonenelemente kaum verankern kann. Allerdings können bei Geweben mit hoher Feinheit auch sehr feine Details gedruckt werden. Die Herstellung von SiebdruckGeweben ist äusserst anspruchsvoll, da die Maschenöffnungen der Gewebe sehr gleichmässig verlaufen müssen. Weltweit gibt es nur sehr wenige Hersteller, die sich auf das Weben von Siebdruckgeweben spezialisiert haben.

Zu den Siebgewebematerialien zählen Polyestergewebe, Nylongewebe und Stahlgewebe. Die Polyestergewebe zeichnen sich durch eine sehr hohe Verzugsfreiheit aus, da sie sehr stark gespannt werde können und keine Feuchtigkeit aufnehmen. Diese Eigenschaften ermöglichen ein sehr passgenaues Druckergebnis. Durch diesen Vorteil werden die Polyestergewebe weltweit für 90% aller Siebdruckarbeiten eingesetzt.

Die Nylongewebe bestehen aus Polyamidfasern, welche dehnbarer und elastischer als Polyesterfasern sind und gegenüber abrasiven Druckfarben sehr beständig sind. Das Nylongewebe wird daher häufig beim Keramikdruck eingesetzt, bei welchem scheuernde Druckpasten verwendet werden. Ein weiterer Einsatzschwerpunkt liegt beim Bedrucken von unebenen Bedruckstoffen. Die Polyamidgewebe sind aufgrund ihrer Plastizität und relativ hohen Feuchtigkeitsaufnahme für passgenäue, grossformatige Druckarbeiten ungeeignet.

Die Stahlgewebe sind sehr hoch spannbar, wodurch sich eine äusserst gute Verzugsfreiheit und Passgenauigkeit beim Drucken ergibt. Zudem sind sie im Vergleich zu Polyestergeweben bei gleicher Siebfeinheit dünneren Ausmasses. Daher haben Stahlgewebe eine grössere Maschenöffnung als beispielsweise Polyestergewebe, wodurch ein höherer Farbauftrag und gleichzeitig auch das Bedrucken von feinsten Linien ermöglicht wird. Allerdings sind Stahlgewebe sehr teuer und empfindlich hinsichtlich von Knicken. Aus diesem Grund werden sie meistens nur im Elektronik- oder Keramikdruck verwendet.

Neueste Generationen von vernickeltem, rostfreiem, gewobenen Stahlgewebe machen die Nachteile des Stahlgewebes durch die hohe Standzeit wett. Zu diesem Stahlgewebe zählt beispielsweise die Screeny S-Line der Gallus Ferd. Rüesch AG, 9016 Sankt Gallen. Im Etikettendruck, bei welchem hauptsächlich der rotative Siebdruck angewendet wird, ist die Screeny S-Line die am häufigsten eingesetzte Siebdruckplatte. Bei dem Rotamesh-Material handelt es sich nicht um ein Gewebe, sondern vielmehr um eine Platte mit sehr feinen wabenartigen Öffnungen. Hierbei sind je nach Druckarbeit verschiedene Lochfeinheiten erhältlich. Die Platten des Rotamesh-Materials werden zu einem runden Zylinder geformt und in Rotationsdruckmaschinen zum Bedrucken von Textilien oder Etiketten eingesetzt. Die Seidengewebe wurden bis in die 50er Jahre im Siebdruck eingesetzt und danach durch Polyamid- oder Polyestergewebe ersetzt.

Im Folgenden wird ein Ablauf einer CtS-(Computer to Screen)-Bebilderung mit einem Ablauf einer herkömmlichen Film-Bebilderung verglichen. Beide Bebilderungsarten beginnen mit dem Schritt des Entwurfs eines Layouts (beispielsweise ein Foto). Beiden Bebilderungsarten ist gemeinsam ein Rasterbildprozess-Schritt RIP (RIP: Raster Image Process) nachgeschaltet. Hierbei werden elektronisch 4-Farb-Bilder der Farben Gelb, Schwarz, Cyan und Magenta verarbeitet. Diesem Schritt folgt lediglich bei der Film-Bebilderung der Schritt einer Filmausgabe, welchem der Schritt einer Retusche folgt. Bei der Retusche werden Fehlstellen von Hand retuschiert. Bei der Retusche besteht jedoch die Gefahr, dass Löcher des Gewebes verschmiert werden können. Es folgt der Schritt eines Filmtransports, beispielsweise zu einer Schablonenmacherei, welchem der Schritt einer Filmpositionierung auf dem Sieb folgt. Diesem Schritt folgt, wie auch bei der CtS-Bebilderung, der Schritt eines Ladens des Siebs in die Belichtungsvorrichtung. Lediglich bei der Film-Bebilderung folgt diesem Schritt ein Schritt zum Anlegen eines Vakuums, bei welchem der Film auf die Schablone angesaugt wird. Diesem Schritt folgt, wie auch bei der CtS-Bebilderung, der Belichtungsschritt. Beiden Bebilderungs-Arten folgt der Schritt eines Entladens des Siebs aus der Belichtungsvorrichtung. Lediglich bei der Film-Bebilderung folgt hiernach der Schritt eines Entfernens des Films, welchem ein Schritt zum Archivieren des Films folgt. Beiden Bebilderungen folgt der Schritt des Entwickelns der Schablone. Lediglich bei der Film-Bebilderung folgt hiernach ein weiterer Retusche-Schritt, bei welchem Staubkörner und Kratzer von Hand retuschiert werden.

Wie anhand der gegenübergestellten Verfahrensabläufe zu erkennen, bei welchen die Film-Bebilderung und die CtS-Bebilderung gegenübergestellt sind, sind zur CtS-Bebilderung weitaus weniger Schritte erforderlich als zur Film-Bebilderung, wodurch sich hohe Zeit- und Kosteneinsparungen erzielen lassen.

Einige Druckvorlagen, beispielsweise Siebdruckschablonen, haben einen starren Metallrahmen, der sich nicht in eine Innentrommel oder auf einer Aussentrommel einer CtP-Anlage zum Belichten aufspannen lässt. Zur Belichtung werden somit Flachbett-Belichter herangezogen, welche eine lineare Bewegung des Belichtungskopfes realisieren. Bei der Belichtung nach dem zuvor genannten Prinzip der X- und Y-Achse wird der Belichtungskopf in Richtung der Breite des zu belichtenden Materials reziprok bei hoher Geschwindigkeit geführt. Diese Achse wird daher häufig als die Speed-Achse bezeichnet. Um diese schnelle Bewegung, die zudem bei hoher konstanter Geschwindigkeit fährt, durchführen zu können, hat sich ein Linearmotor mit Schienenführung als eine gute Lösung herausgestellt. Die linear reziproke Bewegung hat den Nachteil, dass die bewegte Masse, beispielsweise der Belichtungskopf, nach jeder Bewegung beschleunigt und wieder abgebremst werden muss. Um die dabei entstehenden Beschleunigungskräfte so gering wie möglich zu halten, ist es daher wichtig, die bewegte Masse so klein wie möglich zu halten. Bei den meisten Anwendungen ist auf dem linear reziprok bewegten Schlitten jegliches benötigtes Equipment zur Verarbeitung angebracht. Hierzu zählt zumindest die benötigte Optik, mittels derer die Druckvorlage mit einem oder zumeist mehreren Laserstrahlen belichtet wird.

Es sind Flachbett-Belichter bekannt, welche nach dem Prinzip der X- und Y-Achse arbeiten und welche eine Ablationsplatte belichten. Hierbei wird eine belichtete Schicht der Ablationsplatte mit einem Laserstrahl hoher Energie belichtet und somit weggebrannt. Das weggebrannte Material muss direkt beim Belichten abgesaugt werden. Hierbei wird das weggebrannte Material mittels Vakuum unmittelbar an der Optik abgesaugt. Eine mangelnde Absaugung kann zur Folge haben, dass sich das weggebrannte Material auf der Optik ablagert. Somit müssen am Belichtungskopf zusätzlich Einrichtungen zum Absaugen angebracht werden, wodurch die Masse des Belichtungskopfs zusätzlich erhöht wird.

Die EP 1 842 685 B1 zeigt einen CD-ROM-Drucker mit einem ersten freitragenden Führungsarm und einem daran bewegbaren zweiten Führungsarm, an dem wiederum ein Druckkopf bewegbar gelagert ist. Zur Tinten- und Stromversorgung des Druckkopfes ist eine flexible Kabelführung an dem ersten Arm und eine Kabelführung an dem zweiten Arm vorgesehen. Die Führung des Druckkopfes ist somit über zwei Arme hinweg realisiert, wodurch eine Bewegung des Druckkopfes in horizontaler Ebene ermöglicht wird. Nachteilig hieran ist, dass die flexible Kabelführung einen wesentlichen Anteil der reziprok schnell zu bewegenden Masse (Belichtungskopf) bildet.

Die EP 1 892 576 A1 offenbart eine Belichtungsvorrichtung gemäss dem Oberbegriff von Patentanspruch 1 der vorliegenden Erfindung. Hierbei wird der Belichtungskopf relativ zur Druckvorlage nach dem X- und Y-Achsen-Prinzip bewegt. Dabei sind die zur Belichtung vorgesehenen Laserdioden in Modulen angeordnet, welche in einer Weise angeordnet sind, dass sie die Bewegung des Belichtungskopfes nicht oder nur in einer der zur Belichtung des Druckvorlagenmaterials erforderlichen Bewegungsrichtung mitmachen, um die für den Belichtungsvorgang zu bewegende Masse möglichst klein zu halten. Hierbei werden die Lichtsignale der Laserdioden über lichtleitende Fasern dem Belichtungskopf zugeführt. Diese lichtleitenden Fasern und auch zusätzliche Elektrokabel werden in einer Y-Richtung der schnelle reziproken Bewegung des Belichtungskopfes mithilfe von Führungsketten, auch als Schleppketten bezeichnet, geführt. Ferner wird ein Portalarm zur Führung des Belichtungskopfes in einer X-Richtung, welche senkrecht zur Y-Richtung steht, über die Druckvorlage geführt. Um der Bewegung in der X-Richtung zu folgen, sind die lichtleitenden Fasern und zusätzlichen Elektrokabel an diesem Abschnitt ebenfalls mithilfe von Führungsketten geführt.

Nachteilig hieran ist, dass diese Führungsketten einen wesentlichen Anteil der bewegten Masse ausbilden. Ein weiteres Problem besteht darin, dass durch die schnelle reziproke Bewegung, bei welcher pro Sekunde zwei und mehr Bewegungen gefahren werden können, Kabelbrüche in den Zuleitungen auftreten können. Ein weiteres Problem der Verwendung von Führungsketten besteht darin, dass deren Abrollgeräusche und Vibrationen die Genauigkeit beeinflussen können. Zusätzlich sind lange elektrische Leiter und lichtleitende Fasern notwendig, wodurch hohe Kosten entstehen. Ein grosser Nachteil besteht zudem darin, dass Leitungen oder Schläuche mit einem beschränkten Durchmesser innerhalb der Führungskette zu führen sind. Es hat sich herausgestellt, dass beispielsweise Schläuche zum Absaugen von ablatiertem Material mit einem lediglich maximalen Durchmesser von 15 mm innerhalb der Führungskette führbar sind. Um das ablatierte Material zuverlässig absaugen zu können, ist eine hohe Absaugleistung notwendig. Hierzu sind Absaugleitungen mit einem grösseren Durchmesser notwendig. Ferner besteht ein Nachteil darin, dass die in der Führungskette zu führenden elektrischen Leitungen und lichtleitenden Fasern äusserst präzise verlegt werden müssen, wodurch lange Montagezeiten notwendig sind. Hierdurch werden die Kosten erhöht.

Es ist eine Aufgabe der vorliegenden Erfindung, eine verbesserte Belichtungsvorrichtung zur Herstellung von Druckvorlagen anzugeben.

Diese Aufgabe wird durch die Merkmale des Patentanspruchs 1 gelöst.

Eine Belichtungsvorrichtung zur Herstellung von flachen Druckvorlagen enthält eine Halterung für eine Druckvorlage, ein Belichtungssystem, das mindestens eine, einen Lichtstrahl erzeugende Lichtquelle und eine Optik in einem Belichtungskopf aufweist, und ferner eine digitale Signale liefernde Signalquelle, welche über flexible Leitungen mit dem Belichtungssystem in Verbindung steht, wobei der Belichtungskopf in eine Richtung linear und reziprok über die Druckvorlage bewegbar ist und die Halterung für die Druckvorlage in eine Richtung senkrecht zu dieser Richtung des Belichtungskopfes bewegbar ist. Erfindungsgemäss ist der Belichtungskopf mit einem ersten Ende eines teleskopartig ein- und ausziehbaren und in Richtung zur Druckvorlage ausgerichteten Schwenkarms schwenkbar verbunden, dessen zweites Ende mit einer raumfesten Schwenkachse gekoppelt ist, wobei die Leitungen entlang des Schwenkarms verlaufen und so gehalten sind, dass sie entsprechend der Ein- und Auszugsbewegung des Schwenkarms (14) mitbewegbar sind.

Die Verwendung des teleskopartig ein- und ausziehbaren Schwenkarms hat verschiedene Vorteile. Zum einen entfällt die Notwendigkeit der Bereitstellung einer an einem Ende mit dem Belichtungskopf verbundenen Schleppkette zur Führung der Leitungen, welche Schleppkette eine zusätzlich zu bewegende Masse darstellt. Somit wird insgesamt die schnell reziprok zu bewegende Masse reduziert. Dadurch kann der Belichtungskopf mit erhöhter Beschleunigung reziprok bewegt werden, welches höhere Bewegungsfrequenzen und insgesamt kürzere Belichtungszeiten ermöglicht. Ein weiterer Vorteil besteht darin, dass innerhalb der Belichtungsvorrichtung keine oder nur reduzierte Dämpfungsmassen zur Aufnahme bzw. Abfederung von Beschleunigungskräften des sich schnell reziprok bewegenden Belichtungskopfes bereitgestellt werden müssen.

Vorzugsweise sind die Leitungen über einen ersten Abschnitt des Schwenkarms hinweg mit dem Schwenkarm gekoppelt und verlaufen über einen zweiten Abschnitt entkoppelt. Ein Vorteil besteht darin, dass die den Belichtungskopf versorgenden Leitungen, beispielsweise elektrische Leitungen und besonders empfindliche lichtleitende Fasern, kaum Bewegungen erfahren. Hierdurch werden Leitungsbrüche, welche durch längsgerichtete und hochfrequente reziproke Bewegungen entstehen können, nahezu ausgeschlossen. Die Leitungen können beispielsweise mittels Kabelbinder schnell und einfach am ersten Abschnitt des Schwenkarms befestigt bzw. damit gekoppelt werden. Zur freien Bewegbarkeit verlaufen die Leitungen über den zweiten Abschnitt entkoppelt. Somit sind die Leitungen derart am Schwenkarm gehalten, dass sie entsprechend der Ein- und Auszugsbewegung des Schwenkarms mitbewegbar sind.

Vorzugsweise sind die Leitungen über den zweiten Abschnitt des Schwenkarms hinweg an oder in einer Energieführungskette mit einzelnen, um eine jeweilige Achse schwenkbar aneinander gekoppelten Gliedern gehalten. Somit können die Leitungen trotz reziproker Längenänderungen des Schwenkarms, hervorgerufen durch die teleskopartige Ein- und Auszugsbewegung des Schwenkarms, nahezu verschleissfrei geführt werden. Durch die Führung der Leitungen an oder in der Energieführungskette wird zudem die Montagezeit zum Verlegen der elektrischen Leitungen und lichtleitenden Fasern reduziert.

Vorzugsweise ist die Energieführungskette so ausgebildet und angeordnet, dass sich deren einzelne Glieder abhängig von der Ein- und Auszugsbewegung des Schwenkarms derart ausrichten, dass die Form der Energieführungskette mit Auszugsbewegung des Schwenkarms verlängerbar und mit Einzugsbewegung des Schwenkarms verkürzbar ist. Somit kann auf den Gebrauch von Schleppketten zur Führung der Leitungen verzichtet werden. Hierdurch wird insgesamt die Masse der Belichtungsvorrichtung reduziert. Ein weiterer Vorteil besteht darin, dass durch Schleppketten hervorgerufene Vibrationen eliminiert werden. Hierdurch wird die Druckpräzision der Belichtungsvorrichtung insgesamt erhöht.

Beispielsweise wird der Belichtungskopf reziprok in Breitenrichtung der Druckvorlage bewegt und wird die Halterung für die Druckvorlage der Länge nach unterhalb des Belichtungskopfes in einer hierzu senkrechten Richtung geführt. Hierbei wird die Halterung über eine Steppachse geführt, welche senkrecht zur Bewegungsachse des Belichtungskopfes, auch Speedachse genannt, verläuft. Ein wesentlicher Vorteil besteht darin, dass Einrichtungen der Belichtungsvorrichtung, mit Ausnahme der Halterung und des Belichtungskopfes, fixiert sein können und nicht bewegbar ausgebildet werden müssen. Hierdurch werden Kosten und Gewicht eingespart. Insgesamt wird der Belichtungskopf relativ zur Druckvorlage über vorzugsweise die gesamte Fläche der Druckvorlage bewegt. Es sind Siebdruckschablonen als Druckvorlagen verwendbar.

Vorzugsweise ist der Belichtungskopf mittels eines Linearmotors bewegbar. Hierdurch lässt sich der Belichtungskopf, beispielsweise auf oder an einer Schiene geführt, auch bei schneller reziproker Bewegung gleichförmig über die Druckvorlage antreiben. Der am Belichtungskopf angelenkte Schwenkarm braucht hierbei keine Antriebselemente enthalten und wird lediglich der reziproken Bewegung des Belichtungskopfes folgend mitgeschwenkt.

Vorzugsweise enthält die Belichtungsvorrichtung eine Absaugeinrichtung zum Absaugen von ablatiertem Material auf der Druckvorlage. Hierdurch können Druckvorlagen belichtet werden, welche als Ablationsplatte ausgebildet sind, wobei das ablatierte Material schnell und zuverlässig abgesaugt werden kann.

Vorzugsweise enthält die Absaugeinrichtung eine Absaugleitung, welche an einem Ende mit einer am Belichtungskopf angeordneten Absaugöffnung verbunden ist. Hierdurch kann das ablatierte Material direkt am Entstehungsbereich der Ablation, nämlich direkt unterhalb des Belichtungskopfes, schnell und zuverlässig abgesaugt werden.

Vorzugsweise ist die Absaugleitung durch den Schwenkarm ausgebildet, welcher rohrförmig ausgebildet ist. Durch diese besonders vorteilhafte Ausbildung ist keine zusätzliche Absaugleitung notwendig, deren Masse ansonsten zur Erhöhung der Masse des reziprok zu bewegenden Belichtungskopfes beiträgt. Mit anderen Worten, wird die Absaugung im bereits vorgesehenen Schwenkarm integriert. Somit wird zusätzlich Gewicht eingespart und werden zusätzlich Kosten reduziert.

Vorzugsweise enthält der Schwenkarm ein erstes und zweites Schwenkarmrohr, welche in Relation zueinander linear bewegbar sind. Somit kann der Schwenkarm der reziproken Bewegung des Belichtungskopfes sehr leicht folgen. An den zwei Umkehrpunkten des Belichtungskopfes sind die zwei Schwenkarmrohre hierbei maximal auseinander geschoben. Hierbei sollten die Längen der beiden Schwenkarmrohre derart ausgewählt sein, dass auch bei maximaler Auslenkung eine sichere und zuverlässige Führung gewährleistet ist. Die lineare Bewegbarkeit der zwei Schwenkarmrohre in Relation zueinander kann auf einfache Art und Weise erzielt werden, indem der Aussendurchmesser des ersten Schwenkarmrohrs, welches in das zweite Schwenkarmrohr eingeführt ist, im wesentlichen gleich dessen Innendurchmesser ist und Gleitdichtungen zwischengesetzt sind.

Vorzugsweise sind das erste und zweite Schwenkarmrohr zueinander luftdicht abgedichtet. Hierdurch kann der als Absaugleitung wirkende Schwenkarm - das ablatierte Material ohne Saugkraftverlust abführen.

Vorzugsweise ist das erste Schwenkarmrohr am Belichtungskopf angeordnet und ist das zweite Schwenkarmrohr an der Schwenkachse angeordnet, wobei ein Abschnitt des zweiten Schwenkarmrohrs in das erste Schwenkarmrohr eingeführt ist. Durch diese Anordnung der Schwenkarmrohre ist eine besonders zuverlässige Führung der zu dem Belichtungskopf verlaufenden Leitungen, beispielsweise elektrische Leitungen und lichtleitende Fasern, möglich. Diese Leitungen können über ihren ersten Abschnitt an dem ersten Schwenkarmrohr geführt bzw. gehalten werden, welches einen grösseren Durchmesser als das zweite Schwenkarmrohr hat. Die Halterung bzw. Führung der Leitungen kann direkt am ersten Schwenkarmrohr beispielsweise mittels mechanischer Kabelverbinder erfolgen. Um eine schnell und einfach bestückbare und zudem wartungsfreundliche Halterung bzw. Führung bereitzustellen, werden die Leitungen innerhalb einer Leitungsführung (Kabelkanal) verlaufend angeordnet, welche wiederum am ersten Schwenkarmrohr befestigt ist.

Vorzugsweise ist ein Ende der Energieführungskette am ersten Schwenkarmrohr befestigt und ist das weitere Ende der Energieführungskette an der Belichtungsvorrichtung fixiert. Hierbei ist die Länge der Energieführungskette derart gewählt, dass diese der Schwenkbewegung des Schwenkarms ausreichend und zuverlässig folgen kann. Die einzelnen Glieder der Energieführungskette sind lediglich in einer Ebene auslenkbar aneinander gekoppelt. Hierbei entspricht diese Ebene gleich der Schwenkebene des Schwenkarms. Im Vergleich zum Stand der Technik, bei welchem die Leitungen im Bereich der gesamten reziproken Führung des Belichtungskopfes innerhalb einer Schleppkettenführung geführt werden, unterliegen die innerhalb der Energieführungskette aufgenommenen Leitungen einer stark verkürzten Bewegung. Zudem werden die Leitungen weitaus geringer ausgelenkt. Somit wird die Wahrscheinlichkeit potentieller Leitungsbrüche wirksam reduziert. Vorzugsweise enthält die Lichtquelle eine Anzahl n gleichartiger, im Wellenlängenbereich von 300 bis 450 nm arbeitender Laserdioden, die von den Signalen der Signalquelle ansteuerbar sind, wobei die Lichtsignale der Laserdioden über eine gleiche Anzahl n lichtleitender Fasern zu einer Rasterplatte im Belichtungskopf geführt sind und der Lichtausgang der Rasterplatte zu einer im Wellenlängenbereich den Laserdioden angepassten Fokussieroptik im Belichtungskopf geleitet ist. Bei der Rasteranordnung einzeln ansteuerbarer Lichtquellen müssen die Laserdioden selbst nicht notwendigerweise in der für die Belichtung des Schablonenmaterials notwendigen Rasteranordnung montiert sein. Vielmehr genügt es, die lichtleitenden Fasern zu einer Rasterplatte im Belichtungskopf zu führen und die Rasterplatte selbst so zu gestalten, dass die lichtleitenden Fasern dort in der für die Belichtung des Schablonenmaterials notwendigen Rasteranordnung erscheinen. Die Rasterplatte ist somit ein Faser-Array, dass die lichtleitenden Fasern aufnimmt und diese in einer Rasteranordnung parallel zur optischen Achse der Fokussieroptik ausrichtet. Somit müssen lediglich Abschnitte der lichtleitenden Fasern bewegt werden, welches zu einer wesentlichen Gewichtsreduktion beiträgt.

Vorzugsweise enthält die Lichtquelle direkt modulierte Laserdioden. Hierdurch entfällt die Notwendigkeit des kontinuierlichen Betriebes und somit kann die Verlustleistung der gesamten Belichtungsvorrichtung wesentlich gesenkt werden. Weiterhin sind der Reaktionsgeschwindigkeit von Laserdioden (zumindest in dem hier interessierenden Anwendungsbereich der Druckvorlage) nach oben kaum Grenzen gesetzt, weil die erreichbaren Grenzfrequenzen im GHz-Bereich liegen. Weiterhin entfällt durch die einfache Ansteuerbarkeit der Laserdioden und die Abwesenheit von lichtablenkenden Spiegeln im Strahlengang eine weitere Ursache unerwünschter Verlustleistung, weil nämlich mit Ausnahme von Absorptionsverlusten in den Materialien im Strahlengang (Optikkomponenten, lichtleitende Fasern) keine zusätzlichen Verluste in Kauf genommen werden müssen.

Vorzugsweise sind die Laserdioden in einem Wellenlängenbereich von 300 bis 950 nm betreibbar.

Die zuvor genannte Aufgabe wird zudem durch eine Verwendung einer Belichtungsvorrichtung zur Herstellung von Druckvorlagen gelöst. Beispielsweise sind Siebdruckschablonen als Druckvorlagen verwendbar.

Im Folgenden wird die Erfindung anhand eines Ausführungbeispiels näher erläutert. Hierbei zeigen:
- Figur 1: eine Draufsicht auf eine Belichtungsvorrichtung zur Herstellung von Druckvorlagen gemäss der vorliegenden Erfindung in einer schematischen Ansicht; und
- Figur 2: eine Perspektivansicht einer Belichtungseinheit.

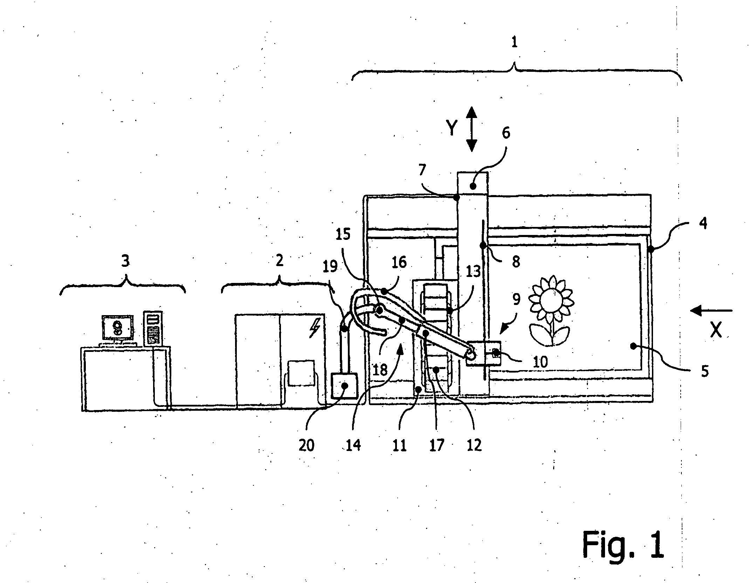

Figur 1 zeigt eine Draufsicht auf eine Belichtungsvorrichtung zur Herstellung von Druckvorlagen, welche im Wesentlichen aus einer Belichtungseinheit 1, einer Steuereinheit 2 und einer Rechnereinheit 3 besteht.

Die Belichtungseinheit 1 umfasst dabei einen horizontal angeordneten Bearbeitungstisch mit einer Halterung 4 für eine (zu belichtende) Druckvorlage 5. Oberhalb der Halterung 4 und der Druckvorlage 5 ist ein Portalarm 6 auf einem Lager 7 angeordnet. Auf dem Portalarm 6 ist, auf einer Y-Achsenführung 8 geführt, ein Belichtungskopf 9 mit einer FokussierOptik 10 in einer in der Figur angezeigten Y-Richtung (Doppelpfeil) reziprok bewegbar. Die mit der Druckvorlage 5 bestückte Halterung 4 ist über eine X-Achsenführung (nicht gezeigt) senkrecht zur Y-Achsenführung 8 in die in der Figur angezeigte X-Richtung bewegbar. Sowohl für die Bewegung in X-Richtung als auch für die reziproke Bewegung in Y-Richtung sind Präzisionsführungen und Präzisionsantriebe vorhanden (nicht dargestellt).

Am Portalarm 6 ist ein Interfaceteil 11 angebracht, auf welchem sich mehrere wärmeableitende Module 12 mit einer Gruppe von Laserdioden sowie ein Datenverteiler und Schnittstellen-Elektronikkomponenten (nicht dargestellt) befinden. Die Module 12 sind über elektrische Leitungen 13 miteinander verbunden. Im Interfaceteil 11 werden die von der Rechnereinheit 3 als Signalquelle stammenden digitalen Signale in optische Signale umgewandelt. Da der Belichtungskopf 9 in Relation zu den Modulen 12 mit den Laserdioden beweglich angeordnet ist, wird die Laserenergie von den Laserdioden über lichtleitende Fasern zum Belichtungskopf 9 übertragen. Hierbei sind die lichtleitenden Fasern über einen ersten Abschnitt eines teleskopartig ein- und ausziehbaren Schwenkarms 14 hinweg an dem Schwenkarm 14 selbst gehalten, so dass diese entsprechend der Ein- und Auszugsbewegung des Schwenkarms 14 mitbewegt werden. Der Schwenkarm ist an einem Ende mit einer raumfesten Schwenkachse 15 gekoppelt. Ferner sind die lichtleitenden Fasern über einen zweiten Abschnitt des Schwenkarms 14 hinweg in einer Energieführungskette 16 mit einzelnen, um eine jeweilige Achse schwenkbar aneinander gekoppelten Gliedern geführt. Die Energieführungskette 16 ist derart ausgebildet und angeordnet, dass sich deren einzelne Glieder abhängig von der Ein- und Auszugsbewegung des Schwenkarms 14 derart ausrichten, dass die Form der Energieführungskette 16 mit Auszugsbewegung des Schwenkarms 14 verlängerbar und mit Einzugsbewegung des Schwenkarms 14 verkürzbar ist. Somit wird das Gewicht der lichtleitenden Fasern und von möglichen weiteren Leitungen wirksam durch die Energieführungskette 16 gelagert. Hierdurch trägt dieses Gewicht nicht zum gesamten Gewicht des zu bewegenden Belichtungskopfes 9 bei.

Beispielsweise können auf dem Interfaceteil 11 ein bis acht Module 12 mit Gruppen von je 16 Laserdioden für Laserdioden mit einem Wellenlängenbereich von 300 nm bis 405 nm angeordnet sein. Bei Laserdioden mit einem Wellenlängenbereich von 800 nm bis 950 nm werden beispielsweise acht Laserdioden pro Modul angeordnet. Dies ergibt insgesamt eine Anzahl n von 16 bis 128 Laserdioden mit einem Wellenlängenbereich von 300 nm bis 450 nm, wobei der Lichtausgang jeder Laserdiode über je eine separate lichtleitende Faser über den teleskopartigen Schwenkarm 14 zu einer Rasterplatte (nicht gezeigt) im Belichtungskopf 9 geleitet wird. Die Laserdioden arbeiten vorteilhafterweise in einem Wellehlängenbereich von 300 bis 950 nm, vorzugsweise für lichtempfindliches Material im Blaulichtbereich bei 405 nm. Für ablative Materialien im Wellenlängenbereich von 800 bis 950 nm sind Wellenlängen von 830 nm und 940 nm bevorzugt. Die Laserdioden können in einem direkt modulierten Betrieb betrieben werden, das heisst, dass sie durch ein digitales Signal ansteuerbar sind.

Bei Belichtungsvorrichtungen dieser. Art wird die von der Halterung 4 aufgenommene Druckvorlage 5 durch reziprokes Bewegen des Belichtungskopfes 9 in Y-Richtung und Bewegen der Halterung 4 in X-Richtung vollständig oder teilweise belichtet. Hierbei ist die Bewegung in X-Richtung langsamer als die reziproke Bewegung in Y-Richtung, wobei in Y-Richtung eine sehr viel kleinere Masse bewegt werden muss.

Die Funktion der Steuereinheit 2 besteht grundsätzlich darin, die Bewegung des Belichtungskopfes 9 in Y-Richtung und die Bewegung der Halterung 4 in X-Richtung zu steuern. Die dazu notwendigen Funktionen sind vorteilhafterweise in einer speicherprogrammierbaren Steuerung (SPS-Einheit) realisiert. Die Steuereinheit 2 enthält zudem die zur Bewegungssteuerung notwendigen Treiberschaltungen, usw.

Die Rechnereinheit 3 stellt die auf die Druckvorlage 5 zu belichtenden Daten bereit und steuert den Belichtungsvorgang. Sowohl die Funktionen der Rechnereinheit 3 als auch die Funktionen der Steuereinheit 2 sind aus gattungsgemässen Geräten dem Fachmann wohl bekannt und müssen nicht näher erläutert werden.

Ein besonderer Vorteil der angezeigten Belichtungsvorrichtung liegt in der Bereitstellung des teleskopartigen Schwenkarms 14, welcher an einem Ende schwenkbar mit dem Belichtungskopf 9 und an seinem weiteren Ende schwenkbar mit der raumfesten (fixierten) Schwenkachse 15 verbunden ist. Wie zuvor erwähnt, sind die zur Versorgung des Belichtungskopfes 9 notwendigen elektrischen Leitungen und lichtleitenden Fasern über den ersten Abschnitt des Schwenkarms 14 hinweg an dem Schwenkarm 14 selbst gehalten. Hierbei können diese Leitungen und Fasern mittels mechanischer Befestigungsvorrichtungen (beispielsweise Kabelbinder) am ersten Abschnitt des Schwenkarms 14 mit diesem verbunden werden oder in einer Führung (nicht gezeigt), beispielsweise ein Kabelkanal, gehalten sein, welche wiederum an dem Schwenkarm 14 befestigt ist.

Wie zuvor erwähnt, sind die elektrischen Leitungen und lichtleitenden Fasern über den zweiten Abschnitt des Schwenkarms 14 hinweg in der Energieführungskette 16 gehalten bzw. geführt. Hierbei ist ein erstes Ende der Energieführungskette 16 am teleskopartigen Schwenkarm 14 befestigt und ist das weitere Ende an der Belichtungseinheit 1 fixiert. Somit verlaufen die elektrischen Leitungen und lichtleitenden Fasern über den ersten Abschnitt des Schwenkarms 14 hinweg entlang des Schwenkarms 14 und über den zweiten Abschnitt des Schwenkarms 14 hinweg in der Energieführungskette 16. Weiterführend werden die elektrischen Leitungen und lichtleitenden Fasern zu den Modulen 12 und/oder zum Datenverteiler geleitet und schliessen damit ab (nicht gezeigt).

Beispielsweise kann die Belichtungsvorrichtung zur Herstellung von Ablationsplatten ausgebildet sein, wobei es notwendig ist, dass das ablatierte Material schnell und sicher abgesaugt wird. Hierzu kann am Belichtungskopf 9 eine Absaugöffnung (nicht gezeigt) angeordnet sein, deren Öffnung in Richtung der Belichtung nach unten ausgerichtet ist. Diese Absaugöffnung ist wiederum in abgedichteter Art und Weise mit dem am Belichtungskopf 9 schwenkbar befestigten Ende des Schwenkarms 14 verbunden. Der Schwenkarm 14 besteht wiederum aus einem ersten Schwenkarmrohr 17 und einem zweiten Schwenkarmrohr 18, welche in Relation zueinander linear bewegbar sind. Hierbei ist das zweite Schwenkarmrohr 18 lediglich in das erste Schwenkarmrohr 17 eingeführt. In einer besonders einfachen und wirksamen Ausgestaltung entspricht der Aussendurchmesser des zweiten Schwenkarmrohrs 18 gleich dem Innendurchmesser des ersten Schwenkarmrohrs 17. Alternativ oder zusätzlich können weitere Führungselemente zum sicheren Führen des ersten Schwenkarmrohrs 17 und des zweiten Schwenkarmrohrs 18 in Relation zueinander vorgesehen sein. Um eine möglichst reibungsarme Führung zwischen dem ersten Schwenkarmrohr 17 und dem zweiten Schwenkarmrohr 18 bereitzustellen, können an der Verbindungsstelle zwischen ihnen Gleitreibungselemente (nicht gezeigt) vorgesehen sein. Eine besonders einfache und wirksame Massnahme zur Reduktion von Reibkräften besteht in der Einführung von Schmieröl/-fett oder Gleitdichtungen im Bereich der Verbindung und Führung zwischen ihnen.

Beide Schwenkarmrohre 17, 18 sind rohrförmig ausgebildet und ferner steht das schwenkbar an der Schwenkachse 15 gekoppelte Ende des zweiten Schwenkarmrohrs 18 luftdicht über eine Absaugleitung 19 mit einer Absaugeinrichtung 20 in Verbindung. Alternativ kann die Absaugeinrichtung 20 auch ohne Zwischenschaltung der Absaugleitung 19 mit dem oben genannten Ende des zweiten Schwenkarmrohrs 18 in Verbindung stehen. Hierbei kann die Schwenkachse 15 direkt mit dem Ende des zweiten Schwenkarmrohrs 18 in Verbindung stehen, wobei die Schwenkachse 15 ebenfalls rohrförmig ausgebildet ist und direkt mit der Absaugeinrichtung 20 verbunden ist.

Zusammengefasst ist eine fluiddichte Verbindung zwischen der am Belichtungskopf 9 angeordneten Absaugöffnung und der Absaugeinrichtung 20 bereitgestellt. Ein wesentlicher Abschnitt dieser Fluidverbindung verläuft hierbei durch den Schwenkarm 14 selbst hindurch. Um einen Saugkraftverlust zu vermeiden, sind das erste und zweite Schwenkarmrohr 17, 18 zueinander fluiddicht linear bewegbar miteinander gekoppelt. Ein besonderer Vorteil dieser Ausgestaltung besteht darin, dass kein zusätzlicher Absaugschlauch bereitgestellt werden muss, da die Absaugung in dem Schwenkarm 14 selbst integriert ist. Zudem hat der gesamte Verlauf zur Absaugung einen vergrösserten Querschnitt, wodurch eine hohe Absaugleistung gewährleistet wird.

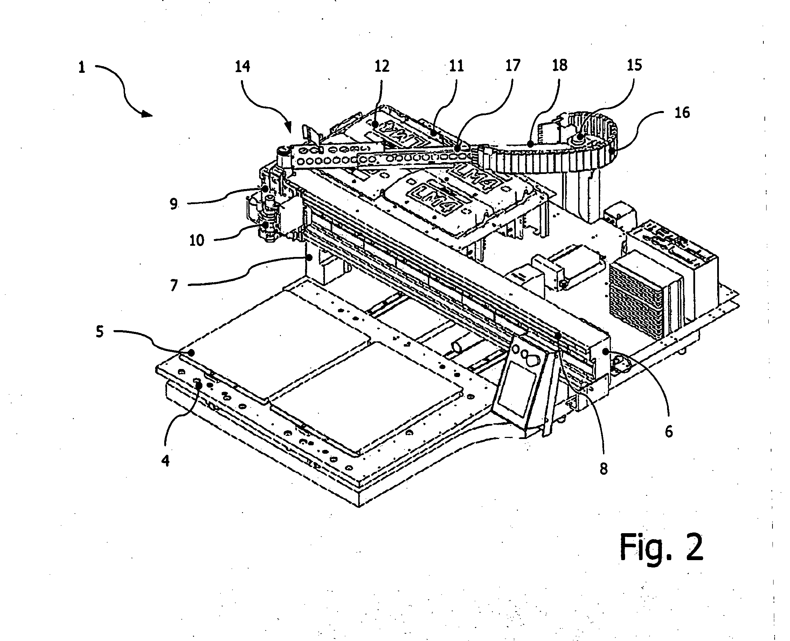

Figur 2 zeigt eine Perspektivdarstellung einer Belichtungseinheit 1 gemäss der schematischen Darstellung von Figur 1 in einer detaillierten Ansicht. Es sind gleiche Elemente, Bauteile oder Komponenten mit den gleichen Bezugszeichen versehen und eine wiederholte Beschreibung derer wird ausgelassen. Ein Vorteil der angezeigten Belichtungseinheit 1 besteht darin, dass auf eine Schleppkettenführung zum Führen der elektrischen Leitungen und der lichtleitenden Fasern verzichtet werden kann. Hierdurch reduziert sich wesentlich die zu bewegende Masse des Belichtungskopfes 9. Um die zu bewegende Masse ferner zu reduzieren, können Materialeinsparungen am ersten und zweiten Schwenkarmrohr 17, 18 vorgenommen werden, wie in der Figur 2 angezeigt. Zur weiteren Gewichtsreduktion können das erste und zweite Schwenkarmrohr 17, 18 aus einem Material mit geringem Gewicht bei zugleich hoher Formstabilität erstellt sein. Dadurch sind höhere Beschleunigungen des Belichtungskopfes 9 möglich, wodurch die reziproke Bewegung (Frequenz) des Belichtungskopfes 9 erhöht werden kann. Dies hat insgesamt verkürzte Zeiten zum Belichten der Druckvorlage 5 zur Folge. Durch die Einsparung der Schleppkettenführung werden hierdurch hervorgerufene zusätzliche Vibrationen eliminiert. Hierdurch erfolgt eine präzise Belichtung der Druckvorlage 5, wodurch insgesamt eine höhere Druckpräzision erzielt wird. Ein weiterer Vorteil der angezeigten Belichtungseinheit 1 besteht darin, dass die elektrischen Leitungen und lichtleitenden Fasern lediglich minimal bewegt bzw. ausgelenkt werden, wodurch die Wahrscheinlichkeit von Leitungsbrüchen stark reduziert wird. Ein weiterer Vorteil besteht darin, dass die gesamte Länge zum Führen der elektrischen Leitungen und lichtleitenden Fasern im Vergleich zum Stand der Technik reduziert ist. Zudem werden Montagezeiten zum Verlegen der elektrischen Leitungen und lichtleitenden Fasern reduziert. Hierdurch lassen sich insgesamt Kosteneinsparungen realisieren.

Durch die vorteilhafte Ausgestaltung wird eine maximale Arbeitsfläche von 600 x 800 mm erzielt. Es sind jedoch maximale Arbeitsflächen von 1200 x 1200 mm erzielbar. Zur Belichtung sind Laserdioden mit einer Wellenlänge von 405 nm / 940 nm einsetzbar. Die 405-nm-Laserdioden können hierbei bevorzugt zur Belichtung von Offsetplatten und Druckvorlagen herangezogen werden, während die Laserdioden im 940-nm-Wellenbereich bevorzugt zur Belichtung von Flexoplatten und Buchdruckplatten herangezogen werden können. Es sind Auflösungen im Bereich von 1200 dpi und 2400 dpi erzielbar. Bei der Verwendung von Laserdioden im 405-nm-Wellenbereich sind maximal 64 Laserdioden und minimal 16 Laserdioden bestückbar. Bei der Verwendung von Laserdioden im 940-nmWellenbereich sind maximal 32 Laserdioden und minimal 8 Laserdioden bestückbar. Die Belichtungsgeschwindigkeit kann hierbei 40 mm pro Minute betragen. Bei der Bestückung mit 32 Laserdioden sind Belichtungageschwindigkeiten von 80 mm pro Minute möglich. Es ist eine Auflösung von 2400 dpi erzielbar. Bei der Bestückung mit 64 Laserdioden sind Belichtungsgeschwindigkeiten von 160 mm pro Minute möglich. Es ist eine Auflösung von 2400 dpi erzielbar.

Ein Vorteil der Direktbelichtung besteht zudem darin, dass kein Filmbelichter notwendig ist. Somit entstehen auch keine Entsorgungskosten einer Entwicklungschemie. Ferner ist keine Filmmontage von Nöten, wodurch Zeit eingespart wird. Ein weiterer Vorteil besteht darin, dass kein Vakuumkopierrahmen bereitgestellt werden muss, wodurch zusätzlich Kosten reduziert werden. Zusätzlich ist kein Unterstrahlen und kein Retuschieren notwendig. Aufgrund der digitalen Vorhaltung kann auch die sonst übliche Filmarchivierung eingespart werden. Dank eines Registersystems sind exakte Passergenauigkeiten erzielbar, wodurch sich grosse Makulatureinsparungen ergeben. Zudem ist die Zeit zur Druckformenherstellung stark reduziert.

Wie zuvor erwähnt, kann eine Arbeitsfläche von 600 x 800 mm belichtet werden und sind Arbeitsflächen von 1200 x 1200 mm belichtbar. Hierdurch ist ein grosser Anwendungsbereich für die Erstellung von Etiketten, flexiblen Verpackungen, Aufdrucken im Automobil-Sektor (beispielsweise Tachoanzeigen), Schiebebildern, Fototaschen und Körperdruckartikeln, wie beispielsweise Gläser, Tuben, Flaschen usw., abgedeckt.

## Patentansprüche

1. Belichtungsvorrichtung zur Herstellung von flachen Druckvorlagen, mit einer Halterung (4) für eine Druckvorlage (5) und mit einem Belichtungssystem, das mindestens eine, einen Lichtstrahl erzeugende Lichtquelle und eine Optik in einem Belichtungskopf (9) aufweist, ferner mit einer digitale Signale liefernden Signalquelle, welche über flexible Leitungen mit dem Belichtungssystem in Verbindung steht, wobei der Belichtungskopf (9) in eine Richtung linear und reziprok über die Druckvorlage (5) bewegbar ist und die Halterung (4) für die Druckvorlage (5) in eine Richtung senkrecht zu dieser Richtung des Belichtungskopfes (9) bewegbar ist, **dadurch gekennzeichnet, dass** der Belichtungskopf (9) mit einem ersten Ende eines teleskopartig ein- und ausziehbaren und in Richtung zur Druckvorlage ausgerichteten Schwenkarms (14) schwenkbar verbunden ist, dessen zweites Ende mit einer raumfesten Schwenkachse (15) gekoppelt ist, wobei die Leitungen entlang des Schwenkarms (14) verlaufen und so gehalten sind, dass sie entsprechend der Ein- und Auszugsbewegung des Schwenkarms (14) mitbewegbar sind.

2. Belichtungsvorrichtung nach Anspruch 1, wobei die Leitungen über einen ersten Abschnitt des Schwenkarms (14) hinweg mit dem Schwenkarm (14) gekoppelt sind und über einen zweiten Abschnitt entkoppelt verlaufen.

3. Belichtungsvorrichtung nach Anspruch 2, wobei die Leitungen über den zweiten Abschnitt des Schwenkarms (14) hinweg an oder in einer Energieführungskette (16) mit einzelnen, um eine jeweilige Achse schwenkbar aneinander gekoppelten Gliedern gehalten sind.

4. Belichtungsvorrichtung nach Anspruch 3, wobei die Energieführungskette (16) so ausgebildet und angeordnet ist, dass sich deren einzelne Glieder abhängig von der Ein- und Auszugsbewegung des Schwenkarms (14) derart ausrichten, dass die Form der Energieführungskette (16) mit Auszugsbewegung des Schwenkarms (14) verlängerbar und mit Einzugsbewegung des Schwenkarms (14) verkürzbar ist.

5. Belichtungsvorrichtung nach einem der vorhergehenden Ansprüche, wobei der Belichtungskopf (9) mittels eines Linearmotors bewegbar ist.

6. Belichtungsvorrichtung nach einem der vorhergehenden Ansprüche, welche eine Absaugeinrichtung (20) zum Absaugen von ablatiertem Material auf der Druckvorlage (5) enthält.

7. Belichtungsvorrichtung nach Anspruch 6, wobei die Absaugeinrichtung (20) eine Absaugleitung (19) enthält, welche an einem Ende mit einer am Belichtungskopf (9) angeordneten Absaugöffnung verbunden ist.

8. Belichtungsvorrichtung nach Anspruch 7, wobei die Absaugleitung (19) durch den Schwenkarm (14) ausgebildet ist, welcher rohrförmig ausgebildet ist.

9. Belichtungsvorrichtung nach einem der vorhergehenden Ansprüche, wobei der Schwenkarm (14) ein erstes (17) und zweites (18) Schwenkarmrohr enthält, welche in Relation zueinander linear bewegbar sind.

10. Belichtungsvorrichtung nach Anspruch 9, wobei das erste (17) und zweite (18) Schwenkarmrohr zueinander luftdicht abgedichtet sind.

11. Belichtungsvorrichtung nach Anspruch 9 oder 10, wobei das erste Schwenkarmrohr (17) am Belichtungskopf (9) angeordnet ist und das zweite Schwenkarmrohr (18) an der Schwenkachse (15) angeordnet ist, wobei ein Abschnitt des zweiten Schwenkarmrohrs (18) in das erste Schwenkarmrohr (17) eingeführt ist.

12. Belichtungsvorrichtung nach einem der Ansprüche 9 bis 11, wobei ein Ende der Energieführungskette (16) am ersten Schwenkarmrohr (17) befestigt ist und das weitere Ende der Energieführungskette (16) an der Belichtungsvorrichtung fixiert ist.

13. Belichtungsvorrichtung nach einem der vorhergehenden Ansprüche, wobei die Lichtquelle eine Anzahl n gleichartiger, im Wellenlängenbereich von 300 bis 450 nm arbeitender Laserdioden enthält, die von den Signalen der Signalquelle ansteuerbar sind, wobei die Lichtsignale der Laserdioden über eine gleiche Anzahl n lichtleitender Fasern zu einer Rasterplatte im Belichtungskopf (9) geführt sind und der Lichtausgang der Rasterplatte zu einer im Wellenlängenbereich den Laserdioden angepassten Fokussieroptik im Belichtungskopf (9) geleitet ist.

14. Belichtungsvorrichtung nach Anspruch 13, wobei die Lichtquelle direkt modulierte Laserdioden enthält.

15. Belichtungsvorrichtung nach einem der Ansprüche 1 bis 12, wobei die Laserdioden in einem Wellenlängenbereich von 300 bis 950 nm betreibbar sind.

16. Verwendung einer Belichtungsvorrichtung nach einem der Ansprüche 1 bis 15 zur Herstellung von Druckvorlagen.

## Claims

1. An exposure device for producing flat printing originals, comprising a mount (4) for a printing original (5) and comprising an exposure system, which has at least one light source which generates a light beam and an optical unit in an exposure head (9), furthermore comprising a signal source, which supplies digital signals and which is connected to the exposure system via flexible lines, wherein the exposure head (9) is movable in a direction linearly and reciprocally over the printing original (5) and the mount (4) for the printing original (5) is movable in a direction perpendicular to this direction of the exposure head (9) **characterised in that** the exposure head (9) is pivotably connected to a first end of a telescopically retractable and extendable pivoting arm (14) which is aligned towards the printing original, the second end of which is coupled to a spatially fixed pivoting spindle (15), wherein the lines run along the pivoting arm (14) and are held in such a way that they are concomitantly movable in accordance with the retraction and extension movement of the pivoting arm (14).

2. The exposure device according to claim 1, wherein the lines are coupled across a first section of the pivoting arm (14) to the pivoting arm (14) and run decoupled over a second section.

3. The exposure device according to claim 2, wherein across the second section of the pivoting arm (14) on or in an energy guiding chain (16) the lines are held by means of individual links which are pivotably coupled to one another about a respective axis.

4. The exposure device according to claim 3, wherein the energy guiding chain (16) is configured and disposed in such a manner that the individual links thereof are aligned depending on the retraction and extending movement of the pivoting arm (14) in such a manner that the shape of the energy guiding chain (16) can be lengthened with the extending movement of the pivoting arm (14) and can be shortened with the retraction movement of the pivoting arm (14).

5. The exposure device according to any one of the preceding claims, wherein the exposure head (9) is movable by means of a linear motor.

6. The exposure device according to any one of the preceding claims, which includes an extraction device (20) for extracting ablated material from the printing original (5).

7. The exposure device according to claim 6, wherein the extraction device (20) contains an extraction line (19), which is connected at one end to an extraction opening disposed on the exposure head (9).

8. The exposure device according to claim 7, wherein the extraction line (19) is formed by the pivoting arm (14), which is configured to be tubular.

9. The exposure device according to any one of the preceding claims, wherein the pivoting arm (14) includes a first (17) and a second (18) pivoting arm tube, which are movable linearly in relation to one another.

10. The exposure device according to claim 9, wherein the first (17) and second (18) pivoting arm tube are sealed in an airtight manner with respect to one another.

11. The exposure device according to claim 9 or 10, wherein the first pivoting arm tube (17) is disposed on the exposure head (9) and the second pivoting arm tube (18) is disposed on the pivoting spindle (15), wherein a section of the second pivoting arm tube (18) is inserted into the first pivoting arm tube (17).

12. The exposure device according to one of claims 9 to 11, wherein one end of the energy guiding chain (16) is fixed on the first pivoting arm tube (17) and the other end of the energy guiding tube (16) is fixed on the exposure device.

13. The exposure device according to any one of the preceding claims, wherein the light source contains a number n of laser diodes of the same type, operating in the wavelength range of 300 to 450 nm, which can be triggered by signals of the signal source, wherein the light signals of the laser diodes are guided via the same number n of light-guiding fibres to a raster plate in the exposure head (9) and the light output of the raster plate is guided to a focusing optics adapted to the laser diodes in the wavelength range in the exposure head (9).

14. The exposure device according to claim 13, wherein the light source contains directly modulated laser diodes.

15. The exposure device according to any one of claims 1 to 12, wherein the laser diodes can be operated in a wavelength range from 300 to 950 nm.

16. Use of an exposure device according to any one of claims 1 to 15 to produce printing originals.

## Revendications

1. Dispositif d'exposition à la lumière pour la fabrication de maquettes plates, avec une fixation (4) pour une maquette (5) et avec un système d'exposition à la lumière qui présente au moins une source de lumière générant un rayon lumineux et une optique dans une tête d'exposition à la lumière (9), avec en outre une source de signaux délivrant des signaux numériques, laquelle est en liaison via des conducteurs flexibles avec le système d'exposition à la lumière, la tête d'exposition à la lumière (9) pouvant être déplacée linéairement dans une direction et de manière réciproque au-dessus de la maquette (5), et la fixation (4) pour la maquette (5) pouvant être déplacée perpendiculairement à cette direction de la tête d'exposition à la lumière (9),
**caractérisé en ce que** la tête d'exposition à la lumière (9) est reliée de manière pivotante à une première extrémité d'un bras pivotant (14), rétractable et déployable télescopiquement et en direction vers la maquette, dont la deuxième extrémité est couplée à un axe de pivotement (15) fixe dans l'espace, les conducteurs s'étendant le long du bras pivotant (14) et étant maintenus de manière à pouvoir suivre le mouvement de rétraction et de déploiement du bras pivotant (14) de façon correspondante.

2. Dispositif d'exposition à la lumière selon la revendication 1, dans lequel les conducteurs sont couplés, par-delà un premier tronçon du bras pivotant (14), au bras pivotant (14) et s'étendent de manière découplée sur un deuxième tronçon.

3. Disposition d'exposition à la lumière selon la revendication 2, dans lequel les conducteurs sont maintenus, par-delà le deuxième tronçon du bras pivotant (14), sur une chaîne de conduction d'énergie (16) avec des éléments individuels couplés de manière pivotante les uns aux autres autour d'un axe respectif, ou dans celle-ci.

4. Dispositif d'exposition à la lumière selon la revendication 3, dans lequel la chaîne de conduction d'énergie (16) est réalisée et disposée de manière à ce que ses éléments individuels s'orientent en fonction du mouvement de rétraction et de déploiement du bras pivotant (14) de manière à ce que la forme de la chaîne de conduction d'énergie (16) puisse être rallongée avec le mouvement de déploiement du bras pivotant (14) et être raccourcie avec le mouvement de rétraction du bras pivotant (14).

5. Dispositif d'exposition à la lumière selon l'une des revendications précédentes, dans lequel la tête d'exposition à la lumière (9) peut être déplacée au moyen d'un moteur linéaire.

6. Dispositif d'exposition à la lumière selon l'une des revendications précédentes, lequel contient un dispositif d'aspiration (20) pour l'aspiration de matière éliminée par ablation sur la maquette (5).

7. Dispositif d'exposition à la lumière selon la revendication 6, dans lequel le dispositif d'aspiration (20) contient un conduit d'aspiration (19) qui est relié, à une extrémité, à une ouverture d'aspiration disposée sur la tête d'exposition à la lumière (9).

8. Dispositif d'exposition à la lumière selon la revendication 7, dans lequel le conduit d'aspiration (19) est formé par le bras pivotant (14), lequel est réalisé en forme de tube.

9. Dispositif d'exposition à la lumière selon l'une des revendications précédentes, dans lequel le bras pivotant (14) contient un premier (17) et un deuxième (18) tube de bras pivotant, lesquels peuvent être déplacés linéairement l'un par rapport à l'autre.

10. Dispositif d'exposition à la lumière selon la revendication 9, dans lequel le premier (17) et le deuxième (18) tube de bras pivotant sont rendus étanches à l'air l'un par rapport à l'autre.

11. Dispositif d'exposition à la lumière selon la revendication 9 ou 10, dans lequel le premier tube de bras pivotant (17) est disposé sur la tête d'exposition à la lumière (9) et le deuxième tube de bras pivotant (18) sur l'axe de pivotement (15), dans lequel un tronçon du deuxième tube de bras pivotant (18) est introduit dans le premier tube de bras pivotant (17).

12. Dispositif d'exposition à la lumière selon l'une des revendications 9 à 11, dans lequel une extrémité de la chaîne de conduction d'énergie (16) est fixée au premier tube de bras pivotant (17) et la deuxième extrémité de la chaîne de conduction d'énergie (16) étant fixée au dispositif d'exposition à la lumière.

13. Dispositif d'exposition à la lumière selon l'une des revendications précédentes, dans lequel la source de lumière contient un certain nombre n de diodes laser similaires, travaillant dans la plage des longueurs d'ondes de 300 à 450 nm, lesquelles peuvent être commandées par les signaux de la source de signaux, dans lequel les signaux lumineux des diodes laser sont guidés via un nombre n identique de fibres optiques vers une plaque tramée dans la tête d'exposition à la lumière (9) et la sortie de lumière de la plaque tramée étant menée vers une optique de focalisation, adaptée aux diodes laser dans la plage de longueurs d'ondes, dans la tête d'exposition à la lumière (9).

14. Dispositif d'exposition à la lumière selon la revendication 13, dans lequel la source de lumière contient des diodes laser directement modulées.

15. Dispositif d'exposition à la lumière selon l'une des revendications 1 à 12, dans lequel les diodes laser peuvent être exploitées dans une plage de longueurs d'ondes de 300 à 950 nm.

16. Utilisation d'un dispositif d'exposition à la lumière selon l'une des revendications 1 à 15 pour la fabrication de maquettes.
